# EUROPEAN PATENT APPLICATION

(11) **EP 4 836 230 A1**
(43) Date of publication of application: **04.11.2026**
(21) Application number: 25892392.9
(22) Date of filing: 28.10.2025
(51) Int. Cl.: H02J 7/00, G01R 31/382, G01R 31/392, G01R 31/396

(54) **DEVICE AND METHOD FOR CONTROLLING CHARGING OF BATTERY**

(30) Priority: 12.11.2024 KR 20240159764
(71) Applicant: LG Energy Solution, Ltd., Seoul 07335 (KR)
(72) Inventor: LEE, Jeong Gon, Daejeon 34122 (KR); KIM, Youjin, Daejeon 34122 (KR); YI, Jaeshin, Daejeon 34122 (KR)
(74) Representative: Plasseraud IP
(86) International application number: PCT/KR2025/017317
(87) International publication number: WO 2026/106184

(57) **Abstract**

A device for controlling charging of a battery, according to an embodiment of the present invention, may comprise: at least one processor; and memory storing at least one instruction that is executed through the at least one processor. Here, the at least one instruction may comprise: an instruction for determining, when a charging mode starts, a fast charging map corresponding to a current state of charge (SOC) from among a plurality of pre-stored fast charging maps; and an instruction for controlling charging of the battery according to the determined fast charging map.

## Description

### [Technical Field]

This application claims priority to and the benefit of Korean Patent Application No.10-2024-0159764 filed in the Korean Intellectual Property Office on November 12, 2024 the entire contents of which are incorporated herein by reference.

The present disclosure relates to a battery charging control apparatus and method, and more particularly, to a battery charging control apparatus and method for controlling battery charging using a fast charging map.

### [Background Art]

Secondary batteries, capable of recharging and reuse, are used as an energy source for small devices such as mobile phones, tablet PCs and vacuum cleaners, and also used as an energy source for medium and large devices such as automobiles and an energy storage system (ESS) for smart grids.

Secondary batteries are applied to systems in the form of assemblies, such as battery modules, in which plurality of battery cells are connected in series and parallel, or battery packs, in which battery modules are connected in series and parallel, depending on the system requirements. For medium- to large-sized devices such as electric vehicles, high-capacity battery systems with plurality of battery modules connected in parallel can be applied to meet the device's capacity requirements.

Recently, with the increasing capacity of secondary batteries, fast (or rapid) charging technologies have emerged that enable faster battery charging.

When charging batteries using fast charging, the charging current needs to be set at an appropriate C-rate to ensure battery life and safety. Typically, a stepwise charging method is used, which initially charges at a high current and then gradually reduces the current as the battery's State of Charge (SOC) or voltage increases.

Generally, the charging current for fast (or rapid) charging may be determined by a predefined fast charging map, which defines charging current values for each SOC range. Specifically, when the battery system switches to charge mode, charging proceeds with a charging current value corresponding to the battery's current SOC. As the battery SOC gradually increases, the SOC ranges are sequentially changed, allowing charging to proceed with a gradual decrease in the charge current value.

In this typical fast charging method, the initial charge current value is determined by the SOC at the start of the charge. If the SOC is high at the start of the charge, charging may begin with a current value lower than the maximum charge current (max C-rate), potentially delaying the charging time.

Among the prior art documents relevant to the present disclosure, KR 10-2020-0075928 A is of some relevance.

### [Detailed Description of the Invention]

### [Technical Problem]

To obviate one or more problems of the related art, embodiments of the present disclosure provide a battery charging control apparatus capable of reducing battery charging time.

To obviate one or more problems of the related art, embodiments of the present disclosure also provide a battery charging method performed by the battery charging control apparatus.

To obviate one or more problems of the related art, embodiments of the present disclosure also provide a battery system including the battery charging control apparatus.

### [Technical Solution]

In order to achieve the objective of the present disclosure, a battery charging control apparatus may include at least one processor; and a memory configured to store at least one instruction executed by the at least one processor.

H ere, the at least one instruction may include instructions to, in response to initiation of a charge mode, determine a fast charging map corresponding to a current State of Charge (SOC) from among a plurality of pre-stored fast charging maps and control charging of the battery according to the determined fast charging map.

Each of the fast charging maps may define a charging current value for each SOC section, the charging current value for each SOC section may be defined to be gradually attenuated as the SOC section increases, and the charging current values for initial SOC sections of each of the fast charging maps may be defined to be the same value.

The initial SOC sections of each of the fast charging maps may be defined to have different ranges.

The charging current values in the final SOC sections of each of the fast charging maps may be defined as the same value.

The instruction to determine the fast charging map corresponding to the current SOC may include an instruction to determine a fast charging map in which the SOC section corresponding to the current SOC is defined as an initial SOC section among the plurality of fast charging maps.

The instruction to control the charging of the battery further may include instructions to, when a charging process according to the determined fast charging map is terminated, calculate an aging degree for the battery based on a state value of the battery; and if the aging degree exceeds a determined value, update the charging current value for each SOC section of each of the fast charging maps.

The at least one instruction may further include instructions to determine whether a predefined fast charging condition is satisfied when a charge mode is initiated; and control the charging of the battery according to a pre-stored standard charging map if the fast charging condition is not satisfied.

The instruction to determine whether the fast charging condition may be satisfied includes an instruction to determine whether one or more of a first condition, in which the charge mode in the previous charging process is the standard charge mode; and a second condition, in which the discharge amount in the previous discharging process exceeds a determined value, is satisfied.

The instruction to control the charging of the battery according to the standard charging map may include an instruction to control the charging of the battery according to the standard charging map if neither the first condition nor the second condition is satisfied.

According to another embodiment of the present disclosure, a battery charging control method, performed by a battery charging control apparatus, may include, in response to initiation of a charge mode, determining a fast charging map corresponding to a current State of Charge (SOC) from among a plurality of pre-stored fast charging maps; and controlling charging of the battery according to the determined fast charging map.

Each of the fast charging maps may define a charging current value for each SOC section, the charging current value for each SOC section may be defined to be gradually attenuated as the SOC section increases, and the charging current values for initial SOC sections of each of the fast charging maps may be defined to be the same value.

The determining of the fast charging map corresponding to the current SOC may include determining a fast charging map in which the SOC section corresponding to the current SOC is defined as an initial SOC section among the plurality of fast charging maps.

The controlling of charging of the battery may include, when a charging process according to the determined fast charging map is terminated, calculating an aging degree for the battery based on a state value of the battery; and if the aging degree exceeds a determined value, updating the charging current value for each SOC section of each of the fast charging maps.

The method may further include determining whether a predefined fast charging condition is satisfied when a charge mode is initiated and controlling the charging of the battery according to a pre-stored standard charging map if the fast charging condition is not satisfied.

The determining of whether the predefined fast charging condition is satisfied may include determining whether one or more of a first condition, in which the charge mode in the previous charging process is the standard charge mode and a second condition, in which the discharge amount in the previous discharging process exceeds a determined value, is satisfied.

The controlling of the charging of the battery according to the standard charging map may include controlling the charging of the battery according to the standard charging map if neither the first condition nor the second condition is satisfied.

According to another embodiment of the present disclosure, a battery charging system may include a battery and a battery charging control apparatus configured to manage and control the battery. Here, the battery charging control apparatus may determine a fast charging map corresponding to a current SOC (State of Charge) from among a plurality of pre-stored fast charging maps in response to initiation of a charge mode, and control charging of the battery according to the determined fast charging map. In addition, each of the fast charging maps may define a charging current value for each SOC section, the charging current value for each SOC section being defined to be gradually attenuated as the SOC section increases, and the charging current values for initial SOC sections of each of the fast charging maps may be defined to be the same value.

### [Advantageous Effects]

According to embodiments of the present disclosure, the charging time of the battery can be shortened by performing charging using an optimal fast charging map corresponding to the current SOC of the battery.

### [Brief Description of the Drawings]

FIG. 1 is a block diagram for illustrating a battery charging system according to embodiments of the present disclosure.
FIG. 2 is a diagram for illustrating a standard charging map according to embodiments of the present disclosure.
FIG. 3 is an operational flowchart of a battery charging control method according to an embodiment of the present disclosure.
FIGS. 4 and 5 are diagrams for illustrating a fast charging map according to embodiments of the present disclosure.
FIG. 6 is an operational flowchart of a battery charging control method according to another embodiment of the present disclosure.
FIG. 7 is an operational flowchart of a battery charging control method according to another embodiment of the present disclosure.
FIG. 8 is a block diagram of a battery charging control apparatus according to embodiments of the present disclosure.

10: battery
100: battery assembly
200, 800: battery charging control apparatus

### [Best Modes for Practicing the Disclosure]

The present disclosure may be modified in various forms and have various embodiments, and specific embodiments thereof are shown by way of example in the drawings and will be described in detail below. It should be understood, however, that there is no intent to limit the present disclosure to the specific embodiments, but on the contrary, the present disclosure is to cover all modifications, equivalents, and alternatives falling within the spirit and technical scope of the present disclosure. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present disclosure. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present disclosure belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery pack or battery rack refers to a system of a single structure which is assembled by electrically connecting module units set by a battery manufacturer and may be monitored and controlled by a battery management apparatus/system (BMS). A battery rack may include several battery modules and a battery protection unit or any other protection device.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present disclosure is not limited to these entities.

State of Charge (SOC) refers to a current state of charge of a battery, represented in percent points [%], and State of Health (SOH) may be a current condition of a battery compared to its ideal or original conditions, represented in percent points [%].

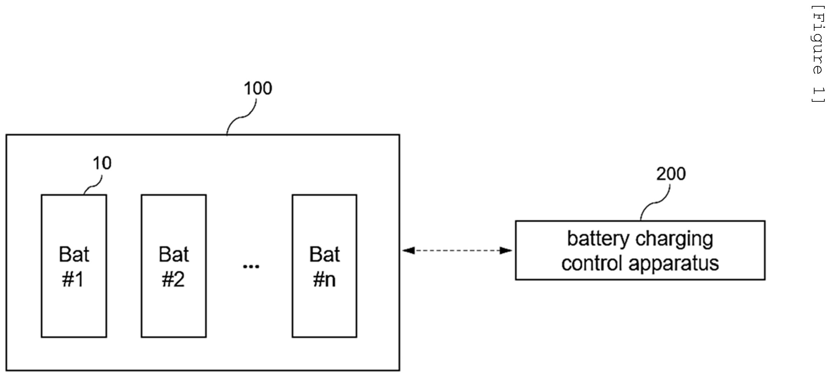

FIG. 1 is a block diagram for illustrating a battery charging system according to embodiments of the present disclosure.

Referring to FIG. 1, the battery charging system may include a battery assembly 100 including a plurality of batteries 10 and a battery charging control apparatus 200.

In the present disclosure, the battery assembly 100 may be incorporated into an electric vehicle or other motorized vehicle, but the scope of the present disclosure is not limited to these entities.

The plurality of batteries 10 may be electrically connected to each other and configured into the battery assembly.

The battery charging control apparatus 200 may be configured to operate in conjunction with the battery assembly 100 and a battery charging device. Here, the battery charging control apparatus 200 may determine a charging current value for charging the battery and control the battery charging device so that the battery is charged according to the determined charging current value.

The battery charging control apparatus 200 may determine the charging current value based on a charging map stored in a memory or storage device and battery status information. For example, the battery charging control apparatus 200 may identify the charging current value corresponding to the battery's SOC, voltage, and temperature from the charging map, and control the battery charging device to charge the battery based on the identified charging current value.

The charging current value determined by the battery charging control apparatus 200 may refer to a charge rate (C-rate) of the charging current applied to the battery 10.

The battery charging control apparatus 200 may include a battery status information collection device that senses battery status values, or may be connected to a battery status information collection device to collect one or more battery status values from the battery status information collection device. Here, the battery status value may include the voltage, current, temperature, internal resistance, SOC, and SOH of the battery.

The battery charging control apparatus 200 may be incorporated into a battery system or a battery charging apparatus. For example, the battery charging control apparatus 200 may correspond to a BMS located within the battery system or a control device for a battery charger.

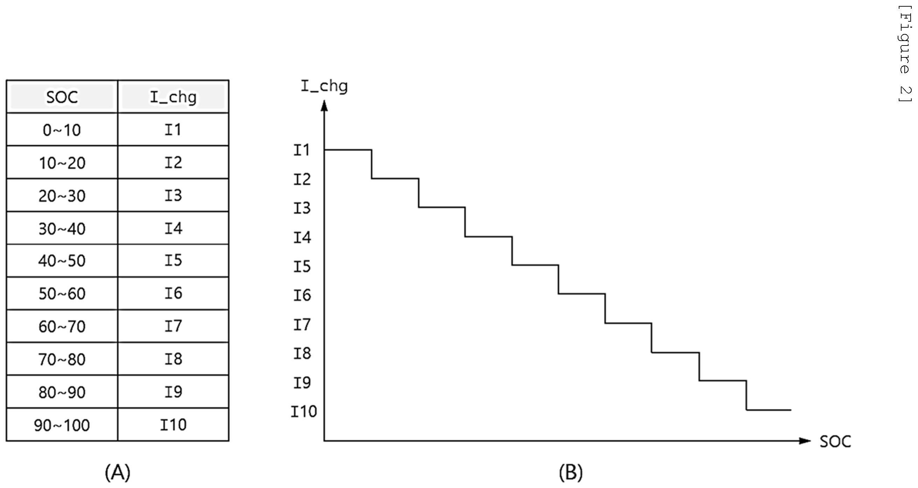

FIG. 2 is a diagram for illustrating a standard charging map according to embodiments of the present disclosure.

The charge current value (I_chg) of the battery may be determined by a pre-stored charging map. Here, the charging map may refer to data defining charge current values (I_chg) for each SOC section (or voltage section). The charging map may be implemented as a table defining charge current values (I_chg) corresponding to each SOC section (or voltage section).

Meanwhile, the charging map may be defined by considering temperature in addition to SOC. For example, the charging map may be implemented as a table defining charge current values for each SOC section and temperature section.

The charge current value (I_chg) for each SOC section (or voltage section) may be defined as a value that gradually decreases as the battery's SOC (or voltage) increases.

A standard charging map (or slow charging map) according to embodiments of the present disclosure may refer to data defining charging current values (I_chg) for each SOC section, from the minimum SOC section to the maximum SOC section. For example, as illustrated in FIG. 2(A), the standard charging map may be implemented as a table defining charging current values (I_chg) for each of ten sections, from the minimum SOC section (SOC [0 to 10]) to the maximum SOC section (SOC [90 to 100]). Here, the charging current values (I_chg) for each SOC section may be defined to gradually attenuate as the SOC section increases, and thus may have a magnitude relationship of I1 > I2 > I3 > I4 > I5 > I6 > I7 > I8 > I9 > I10.

Meanwhile, in the charging map, the size (range) of each SOC section and the total number of SOC sections may be changed as needed.

When the battery system switches to charge mode, the battery charging control apparatus may check the standard charging map (slow charging map) stored in the storage device for a charge current value corresponding to the battery's current SOC (or voltage) and control the charging device to charge the battery at the determined charge current value.

For example, referring to FIGS. 2(A) and (B), if the battery SOC is 25% at the time of switching to charge mode, the battery may be charged at a charge current value of I3. Afterwards, when the battery SOC reaches 30%, the battery may be charged at a charge current value of I4. Thereafter, charging may proceed with a gradual decrease in the charge current value (I4 -> I5 -> I6 -> I7 -> I8 -> I9 -> I10) until the battery charging process is completed.

In charging methods using this standard charging map (slow charging map), the initial charging current value is determined based on the SOC at the initiation of charging. If the SOC at the start of charging is higher than the minimum SOC range, charging begins with a lower charging current value (e.g., I3) than the maximum charging current value (I1), which may delay the charging time until the charging process ends.

In the following, a battery charging control method according to embodiments of the present disclosure is described to address this issue.

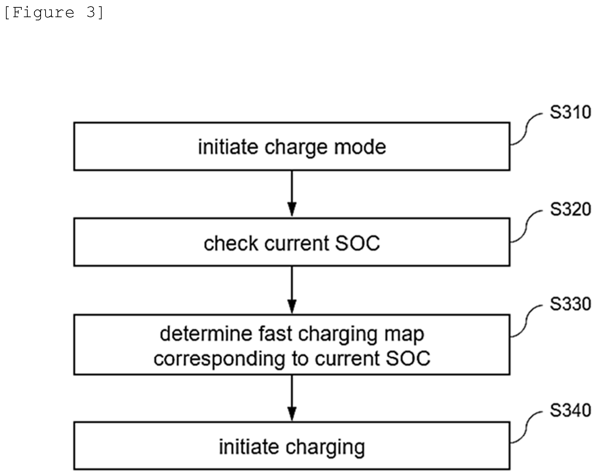

FIG. 3 is an operational flowchart of a battery charging control method according to an embodiment of the present disclosure.

The battery charging control method according to embodiments of the present disclosure may be performed by a battery charging control apparatus included in a battery system or battery charging apparatus.

When the charge mode is initiated (S310), the battery charging control apparatus may check the current SOC of the battery (S320). Here, the battery charging control apparatus may collect the current SOC of the battery from a battery status information collection device or calculate the current SOC of the battery using a battery status value received from the battery status information collection device.

The battery charging control apparatus may determine a fast charging map corresponding to the current SOC from among a plurality of pre-stored fast charging maps (S330). Here, the battery charging control apparatus may determine a fast charging map in which the SOC section corresponding to the current SOC is defined as the initial SOC section among the plurality of fast charging maps.

Thereafter, the battery charging control apparatus may control battery charging according to the fast charging map determined in S330 (S340).

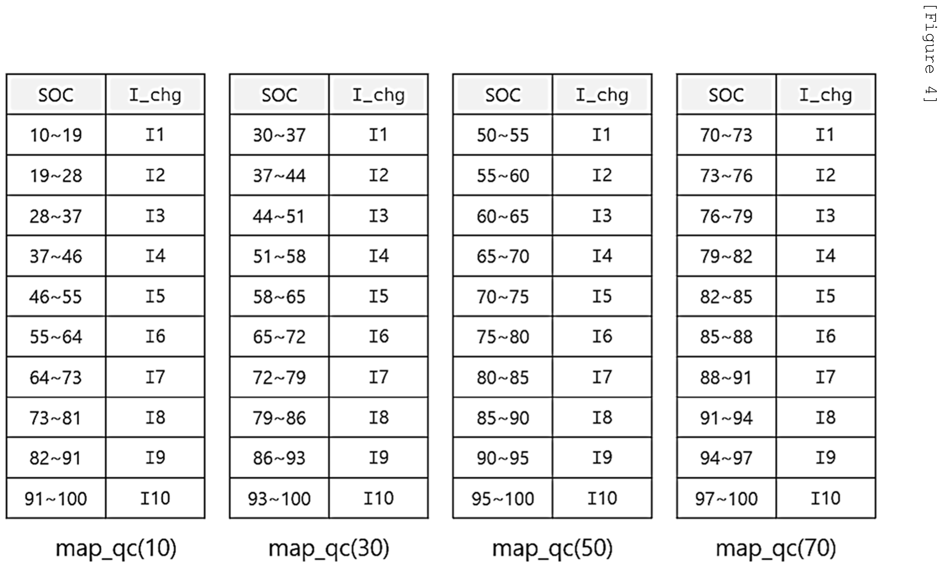

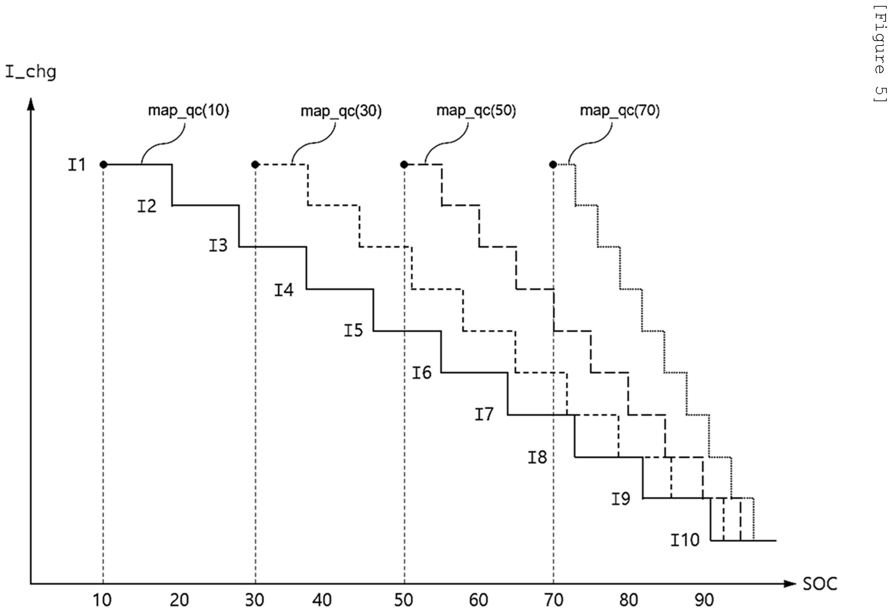

FIGS. 4 and 5 are diagrams for illustrating a fast charging map according to embodiments of the present disclosure.

The fast charging map according to embodiments of the present disclosure may be a charging map defined separately from the standard charging map (slow charging map) of FIG. 2. Plurality of fast charging maps may be pre-stored in a storage device or memory of a battery system.

Each fast charging map defines a charging current value (I_chg) for each SOC section, and the charging current value (I_chg) for each SOC section may be defined to gradually decrease as the SOC section increases. Here, the initial SOC section of each fast charging map may be defined as an SOC section higher than the minimum SOC section (0-10), which is the initial SOC section of the standard charging map.

Furthermore, the initial SOC section of each fast charging map may be defined with different ranges. Meanwhile, the charging current values (I_chg) in the initial SOC sections of each fast charging map may be defined as the same value, and the charging current values in the final SOC sections of each fast charging map may be defined as the same value.

For example, referring to FIG. 4, the first fast charging map (map_qc10) may define a charging current value (I_chg) for each of ten sections, from the initial SOC section [10 to 19] to the final SOC section [91 to 100], and the second fast charging map (map_qc(30)) may define a charging current value (I_chg) for each of ten sections, from the initial SOC section [30 to 37] to the final SOC section [93 to 100]. In addition, the third fast charging map (map_qc(50)) may define a charging current value (I_chg) for each of ten sections from the initial SOC section [50 to 55] to the final SOC section [95 to 100], and the fourth fast charging map (map_qc(70)) may define a charging current value (I_chg) for each of ten sections from the initial SOC section [70 to 73] to the final SOC section [97 to 100].

Here, the charging current value (I_chg) in the initial SOC section of each of the first to fourth fast charging maps may be defined as the same value I1 and the charging current value in the final SOC section may also be defined as the same value I10.

When a charge mode is initiated, the battery charging control apparatus may check the current SOC of the battery and determine a fast charging map corresponding to the current SOC from among plurality of pre-stored fast charging maps. Here, the battery charging control apparatus may determine a fast charging map of which the initial SOC section corresponding to the current SOC is defined, among the plurality of fast charging maps, and control the battery to be charged according to the determined fast charging map.

For example, referring to FIGS. 4 and 5, if the battery's SOC is 35% at the start of the charge mode, the battery may be charged according to map_qc(30). Accordingly, charging may begin with I1, the maximum charging current (max C-rate). Thereafter, the charging current gradually decreases (I1 -> I2 -> I3 -> I4 -> I5 -> I6 -> I7 -> I8 -> I9 -> I10) until the battery charging process is completed, thereby shortening the charge time.

For another example, if the battery's SOC is 52% at the start of the charge mode, the battery may be charged according to map_qc(50). Even in this case, charging may begin with I1, the maximum charge current (max C-rate), and charging may proceed with the charge current gradually decreasing (I1 -> I2 -> I3 -> I4 -> I5 -> I6 -> I7 -> I8 -> I9 -> I10) until the battery charging process is completed.

Meanwhile, FIG. 4 illustrates four fast charging maps as examples for the purpose of understanding the present disclosure. Additional fast charging maps with different initial SOC ranges may be additionally stored in memory or a storage device, as needed.

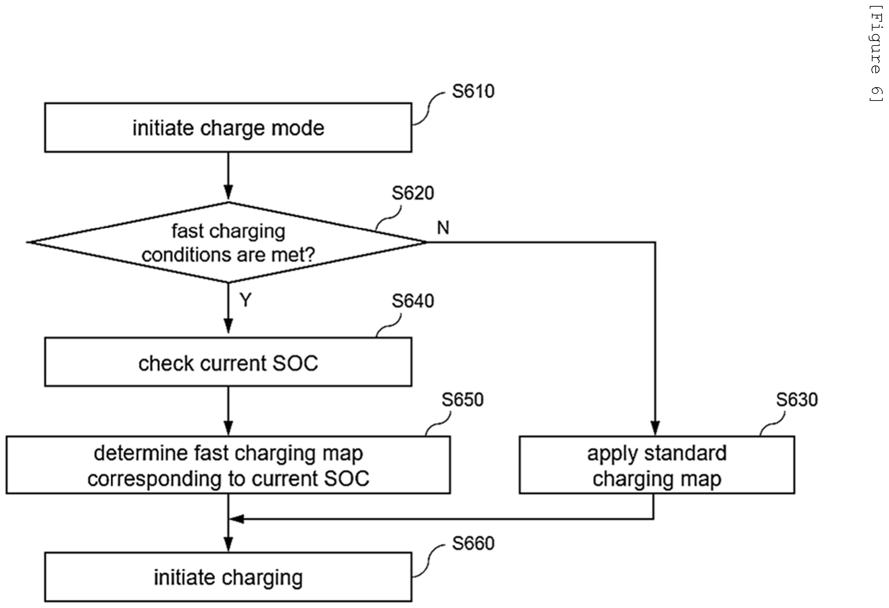

FIG. 6 is an operational flowchart of a battery charging control method according to another embodiment of the present disclosure.

When charge mode is initiated (S610), the battery charging control apparatus may determine whether predefined fast charging conditions are met (S620).

If the fast charging conditions are not met (N in S620), the battery charging control apparatus may determine a pre-stored standard charging map as the charging map for battery charging (S630) and control battery charging according to the standard charging map (S660).

The standard charging map (or slow charging map) may refer to data defining charging current values (I_chg) for each SOC range, from the minimum SOC section to the maximum SOC section. For example, a standard charging map, as illustrated in FIG. 2(A), may be implemented as a table defining charge current values (I_chg) for each of ten sections, from the minimum SOC section (SOC [0 to 10]) to the maximum SOC section (SOC [90 to 100]). Here, the charge current values (I_chg) for each SOC section are defined to gradually decrease as the SOC section increases, and thus have a magnitude relationship of I1 > I2 > I3 > I4 > I5 > I6 > I7 > I8 > I9 > I10.

According to embodiments of the present disclosure, fast charging conditions may include a first condition in which the charge mode in the previous charge process is the standard charge mode; and a second condition in which the discharge amount in the previous discharge process exceeds a determined value. If neither the first condition nor the second condition is satisfied, the battery charging control apparatus may control battery charging according to the standard charging map.

Specifically, the battery charging control apparatus may store the type of charge mode (fast/rapid charge mode or standard charge mode) in memory or a storage device each time a charging process ends. Furthermore, the battery charging control apparatus may store the total discharge amount in memory or a storage device each time a discharging process ends.

When a charge mode is initiated, the battery charging control apparatus may identify the charge mode type from the previous (right before) charging process and the discharge amount from the previous (right before) discharging process, stored in the memory or storage device, to determine whether the first and second conditions are satisfied.

If neither the first nor the second conditions are satisfied, the battery charging control apparatus may determine that the fast charging condition is unsatisfied and control battery charging according to the standard charging map. For example, if the charge mode from the previous charging process was fast charge mode (the first condition is unsatisfied) and the SOC decrease from the previous discharging process is less than a determined value of 10% (the second condition is unsatisfied), the battery may be charged according to the standard charging map (slow charging map).

If the fast charging condition is satisfied (Y in S620), the battery charging control apparatus may check the current SOC of the battery (S640) and determine a fast charging map corresponding to the current SOC from among the plurality of pre-stored fast charging maps (S650). Here, the battery charging control apparatus may determine a fast charging map in which the SOC range corresponding to the current SOC is defined as the initial SOC range among the plurality of fast charging maps.

If one or more of the first and second conditions is satisfied, the battery charging control apparatus may determine that the fast charging condition is satisfied. For example, if the charge mode in the previous charging process is the standard charge mode (satisfying the first condition) or the SOC decrease in the previous discharging process exceeds the set value of 10% (satisfying the second condition), the battery may be charged according to the optimal fast charging map corresponding to the SOC at the start of the charge mode.

According to embodiments of the present disclosure, a fast charging map is defined separately from a standard charging map (slow charging map). Each fast charging map defines a charging current value (I_chg) for each SOC section. The charging current value (I_chg) for each SOC section may be defined to gradually decrease as the SOC section increases. Here, the initial SOC section of each fast charging map may be defined as a SOC section higher than the minimum SOC section (0-10) which is the initial SOC section of the standard charging map.

Furthermore, the initial SOC section of each fast charging map may be defined to have different ranges. Meanwhile, the charging current values (I_chg) in the initial SOC sections of each fast charging map may be defined as the same value and the charging current values in the final SOC sections of each fast charging map may be defined as the same value.

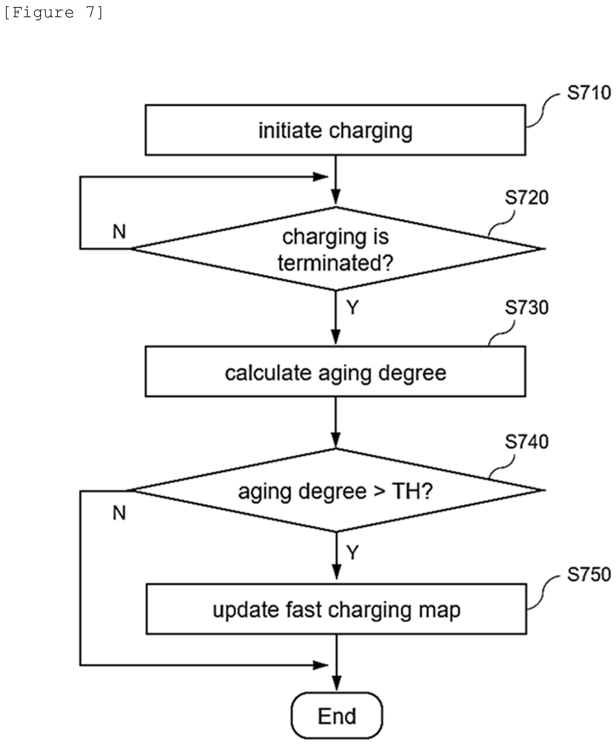

FIG. 7 is an operational flowchart of a battery charging control method according to another embodiment of the present disclosure.

When charging begins (S710), the battery charging control apparatus may control charging termination based on predefined charging termination conditions (S720). The charging termination conditions may include one or more of a third condition, in which the battery SOC (or voltage) reaches a predefined target SOC (or target voltage), and a fourth condition, in which a charging termination signal is received. For example, the battery charging process may be terminated when the battery SOC reaches 100%, or when a forced charging termination signal is received even if the battery SOC does not reach 100%.

When the charging process is terminated (Y in S720), the battery charging control apparatus may calculate a battery aging degree based on the battery state value (S670). The battery aging degree may refer to a numerical value corresponding to the degradation level of the battery.

In an embodiment, the battery charging control apparatus may calculate the aging degree based on the internal resistance of the battery. For example, the battery charging control apparatus may calculate the rate of increase in internal resistance of the battery during a charging process and multiply the rate by a predetermined adjustment factor, so as to calculate the aging degree.

Thereafter, the battery charging control apparatus may compare the aging degree calculated in S730 with a predetermined threshold (TH) (S740). If the aging degree exceeds the threshold (TH) (Y in S740), the stored fast charging map may be updated. Here, the battery charging control apparatus may update the charging current value for each SOC section of each fast charging map.

For example, if the calculated aging degree after the charging process ends is 30 and the predetermined threshold (TH) is 28, the battery charging control apparatus may decrease the charging current value for each SOC section of each fast charging map by a predetermined percentage.

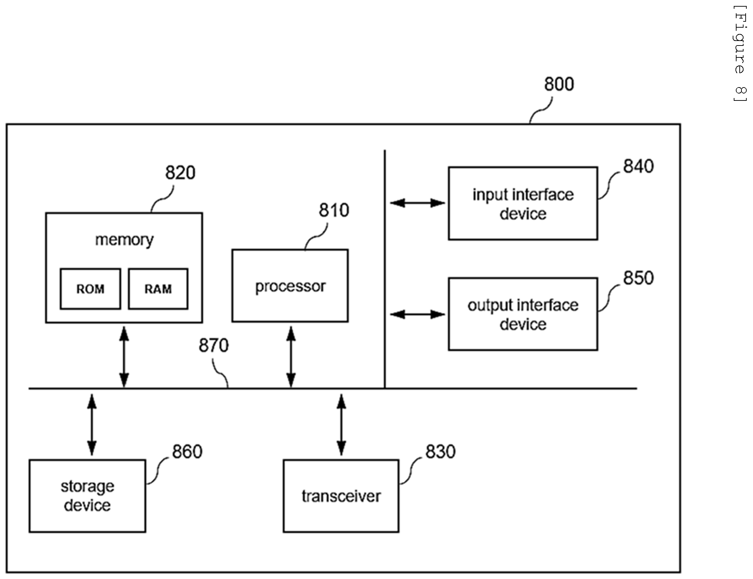

FIG. 8 is a block diagram of a battery charging control apparatus according to embodiments of the present disclosure.

The battery charging control apparatus 800 according to embodiments of the present disclosure may be incorporated into a battery system or may be incorporated into a battery charging apparatus. For example, the battery charging control apparatus 800 may correspond to a BMS located in a battery system or may correspond to a control apparatus of a battery charger.

The battery charging control apparatus 800 may include at least one processor 810, a memory 820 storing at least one instruction executed by the processor, and a transceiver 830 connected to a network to perform communication.

T he at least one instruction may include instructions to, in response to initiation of a charge mode, determine a fast charging map corresponding to a current State of Charge (SOC) from among a plurality of pre-stored fast charging maps and control charging of the battery according to the determined fast charging map.

Each of the fast charging maps may define a charging current value for each SOC section, the charging current value for each SOC section may be defined to be gradually attenuated as the SOC section increases, and the charging current values for initial SOC sections of each of the fast charging maps may be defined to be the same value.

The initial SOC sections of each of the fast charging maps may be defined to have different ranges.

The charging current values in the final SOC sections of each of the fast charging maps may be defined as the same value.

The instruction to determine the fast charging map corresponding to the current SOC may include an instruction to determine a fast charging map in which the SOC section corresponding to the current SOC is defined as an initial SOC section, among the plurality of fast charging maps.

The instruction to control the charging of the battery further may include instructions to, when a charging process according to the determined fast charging map is terminated, calculate an aging degree for the battery based on a state value of the battery; and if the aging degree exceeds a determined value, update the charging current value for each SOC section of each of the fast charging maps.

The at least one instruction may further include instructions to determine whether a predefined fast charging condition is satisfied when a charge mode is initiated; and control the charging of the battery according to a pre-stored standard charging map if the fast charging condition is not satisfied.

The instruction to determine whether the fast charging condition may be satisfied includes an instruction to determine whether one or more of a first condition, in which the charge mode in the previous charging process is the standard charge mode; and a second condition, in which the discharge amount in the previous discharging process exceeds a determined value, is satisfied.

The instruction to control the charging of the battery according to the standard charging map may include an instruction to control the charging of the battery according to the standard charging map if neither the first condition nor the second condition is satisfied.

Furthermore, the battery charging control apparatus 800 according to embodiments of the present disclosure may further include an input interface device 840, an output interface device 850, a storage device 860, etc. Respective components included in the battery charging control apparatus 800 may be connected by a bus 870 and can communicate with each other.

Here, the processor 810 may mean a central processing unit (CPU), a graphics processing unit (GPU), or a dedicated processor on which methods according to embodiments of the present disclosure are performed. Furthermore, the memory may include one or more of a volatile/transitory recording medium and a nonvolatile/non-transitory recording medium. For example, the memory may include at least one of a read-only memory (ROM) and a random access memory (RAM), and may include an Electrically Erasable Programmable Read-only Memory (EEPROM).

The operations of the method according to the embodiments of the present disclosure may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

The operations of the method according to embodiments of the present disclosure may be implemented in various forms related to programs, such as a computer program or code itself, or a computer program product.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present disclosure has been described with reference to the exemplary embodiment of the present disclosure, but those skilled in the art may appreciate that the present disclosure may be variously corrected and changed within the range without departing from the spirit and the area of the present disclosure described in the appending claims.

## Claims

1. A battery charging control apparatus comprising:
at least one processor; and
a memory configured to store at least one instruction executed by the at least one processor,
wherein the at least one instruction includes instructions to:
in response to initiation of a charge mode, determine a fast charging map corresponding to a current SOC from among a plurality of pre-stored fast charging maps; and
control charging of the battery according to the determined fast charging map.

2. The battery charging control apparatus of claim 1, wherein each of the fast charging maps defines a charging current value for each SOC section,
the charging current value for each SOC section is defined to be gradually attenuated as the SOC section increases, and
the charging current values for initial SOC sections of each of the fast charging maps is defined to be the same value.

3. The battery charging control apparatus of claim 2, wherein the initial SOC sections of each of the fast charging maps are defined to have different ranges.

4. The battery charging control apparatus of claim 2, wherein charging current values in the final SOC sections of each of the fast charging maps is defined as the same value.

5. The battery charging control apparatus of claim 2, wherein the instruction to determine the fast charging map corresponding to the current SOC includes an instruction to:
determine a fast charging map in which the SOC section corresponding to the current SOC is defined as an initial SOC section among the plurality of fast charging maps.

6. The battery charging control apparatus of claim 1, wherein the instruction to control the charging of the battery further includes instructions to:
when a charging process according to the determined fast charging map is terminated, calculate an aging degree for the battery based on a state value of the battery; and
if the aging degree exceeds a determined value, update the charging current value for each SOC section of each of the fast charging maps.

7. The battery charging control apparatus of claim 1, wherein the at least one instruction further includes instructions to:
determine whether a predefined fast charging condition is satisfied when a charge mode is initiated; and
control the charging of the battery according to a pre-stored standard charging map if the fast charging condition is not satisfied.

8. The battery charging control apparatus of claim 7, wherein the instruction to determine whether the fast charging condition is satisfied includes an instruction to:
determine whether one or more of a first condition, in which the charge mode in the previous charging process is the standard charge mode; and a second condition, in which the discharge amount in the previous discharging process exceeds a determined value, is satisfied.

9. The battery charging control apparatus of claim 8, wherein the instruction to control the charging of the battery according to the standard charging map includes an instruction to:
control the charging of the battery according to the standard charging map if neither the first condition nor the second condition is satisfied.

10. A battery charging control method, performed by a battery charging control apparatus, comprising:
in response to initiation of a charge mode, determining a fast charging map corresponding to a current SOC from among a plurality of pre-stored fast charging maps; and
controlling charging of the battery according to the determined fast charging map.

11. The battery charging control method of claim 10, wherein each of the fast charging maps defines a charging current value for each SOC section,
the charging current value for each SOC section is defined to be gradually attenuated as the SOC section increases, and
the charging current values for initial SOC sections of each of the fast charging maps is defined to be the same value.

12. The battery charging control method of claim 11, wherein the determining of the fast charging map corresponding to the current SOC includes:
determining a fast charging map in which the SOC section corresponding to the current SOC is defined as an initial SOC section among the plurality of fast charging maps.

13. The battery charging control method of claim 10, wherein the controlling of charging of the battery includes:
when a charging process according to the determined fast charging map is terminated, calculating an aging degree for the battery based on a state value of the battery; and
if the aging degree exceeds a determined value, updating the charging current value for each SOC section of each of the fast charging maps.

14. The battery charging control method of claim 10, further comprising:
determining whether a predefined fast charging condition is satisfied when a charge mode is initiated; and
controlling the charging of the battery according to a pre-stored standard charging map if the fast charging condition is not satisfied.

15. The battery charging control method of claim 14, wherein the determining of whether the predefined fast charging condition is satisfied includes:
determining whether one or more of a first condition, in which the charge mode in the previous charging process is the standard charge mode and a second condition, in which the discharge amount in the previous discharging process exceeds a determined value, is satisfied.

16. The battery charging control method of claim 15, wherein the controlling of the charging of the battery according to the standard charging map includes:
controlling the charging of the battery according to the standard charging map if neither the first condition nor the second condition is satisfied.

17. A battery charging system comprising:
a battery; and
a battery charging control apparatus configured to manage and control the battery,
wherein, the battery charging control apparatus determines a fast charging map corresponding to a current SOC (State of Charge) from among a plurality of pre-stored fast charging maps in response to initiation of a charge mode, and controls charging of the battery according to the determined fast charging map,
each of the fast charging maps defines a charging current value for each SOC section, the charging current value for each SOC section being defined to be gradually attenuated as the SOC section increases, and
the charging current values for initial SOC sections of each of the fast charging maps is defined to be the same value.

18. A computer-readable medium having recorded thereon a program for executing the battery charging control method according to any one of claims 10 to 16 on a computer.
